## Europäisches Patentamt

## European Patent Office

## Office européen des brevets

(19)

(11) Veröffentlichungsnummer: **0 135 597**
**B1**

(12) **EUROPÄISCHE PATENTSCHRIFT**

(45) Veröffentlichungstag der Patentschrift:
**22.07.87**

(21) Anmeldenummer: **83109475.0**

(22) Anmeldetag: **23.09.83**

(51) Int. Cl.⁴: **G 03 B 41/00**

(54) Verfahren und Einrichtung zum gegenseitigen Ausrichten von Objekten.

(43) Veröffentlichungstag der Anmeldung:
**03.04.85 Patentblatt 85/14**

(45) Bekanntmachung des Hinweises auf die Patenterteilung:
**22.07.87 Patentblatt 87/30**

(84) Benannte Vertragsstaaten:
**DE FR GB**

(56) Entgegenhaltungen:
**DE-A-2 951 943**
**DE-A-3 128 802**
**FR-A-2 121 301**
**US-A-3 899 634**
**US-A-4 347 001**

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB**

(72) Erfinder: **Schedewie, Franz, Dr. Dipl.- Phys., Schurwaldstrasse 18, D-7030 Böblingen (DE)**

(74) Vertreter: **Teufel, Fritz, Dipl.- Phys., IBM Deutschland GmbH. Europäische Patentdienste Postfach 265, D-8000 München 22 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1987

## Beschreibung

Die Erfindung betrifft ein Verfahren zum gegenseitigen Ausrichten von Objekten nach dem Oberbegriff des Anspruch 1 und Einrichtungen zur Durchführung des Verfahrens. Ein bevorzugtes Anwendungsgebiet ist die lithographische Herstellung von Halbleiterschaltungen.

Bei vielen Fabrikationsprozessen ist eine sehr genaue Ausrichtung zweier oder mehrerer Gegenstände relativ zueinander erforderlich; ein besonders wichtiges Beispiel hierfür bieten lithographische Verfahren, bei denen eine Belichtungsmaske relativ zu einem Muster ausgerichtet (justiert) werden muß, das auf einem Halbleiterplättchen (Wafer) enthalten ist. Da mit modernen lichtoptischen und insbesondere mit elektronenoptischen Belichtungsverfahren Strukturen, z. B. Leiterzüge, mit Dimensionen im Mikronbereich hergestellt werden können, muß diese Ausrichtung auf Bruchteile eines Mikrons genau erfolgen.

Die bisherige visuelle Ausrichtung unter einem Mikroskop stößt bei derartigen Genauigkeitsanforderungen an ihre Grenzen. Fehlablesungen und subjektive Beurteilungen stellen dabei eine hauptsächliche Fehlerquelle dar, obwohl eine Vielzahl von verschieden ausgestalteten Richtmärken untersucht wurden, die eine möglichst genaue Ablesung erlauben; statt einfacher Fadenkreuze wurden beispielsweise Richtmarken mit ausgeprägten Symmetrieeigenschaften oder Nonienskalen verwendet.

Vorschläge, die visuelle Justierung durch automatische und objektive Verfahren abzulösen, sind in großer Zahl gemacht worden; dabei wird auf optoelektronischem Weg die Lage von Einzelkanten oder von periodischen Strukturen festgestellt. Im ersten Fall werden die Justiermarken auf Maske und Wafer auf entsprechend angeordnete Detektoren abgebildet, beispielsweise eine Fernsehkamera, wie es in der Europäischen Patentschrift 51 567 beschrieben ist. Periodische Ausrichtstrukturen in Form von Strichgittern werden in Anordnungen verwendet, die nach dem Moiré-Prinzip arbeiten oder bei denen die Phasenverschiebung im gebeugten Licht festgestellt wird, die bei einer Verschiebung des Gitters auftritt. Ein Beispiel für ein Ausrichtverfahren mit Gittern, deren Phasenunterschied elektrooptisch festgestellt wird, ist in der Europäischen Patentanmeldung 45 321 beschrieben.

Eine ähnliche Ausrichtvorrichtung ist auch in der FR-B-2 121 301 beschrieben, bei dem auf Maske und Substrat angeordnete Ausrichtgitter auf ein bewegliches Ausrichtgitter abgebildet werden, um den Phasenunterschied zu messen, der zwischen den Amplitudensignalen des von den Gittern durchgelassenen Lichtes besteht. DE-A-3 128 802 beschreibt eine elektrooptische Vorrichtung mit Phasenauswertung zwischen zwei Signalen, die in einem Bezugsstrahlengang bzw. einem Meßstrahlengang eines optischen Systems entstehen, das eine optisch-analoge Faltungsoperation zwischen den Ausrichtmustern auf Maske und Substrat erzeugt. Diese Vorrichtung erfordert eine zeitliche Modulation der Lichtbündel und einen relativ aufwendigen optischen und elektronischen Aufbau.

Alle bisher vorgeschlagenen Verfahren zur Ausrichtung von Maske und Wafer weisen jedoch schwerwiegende Nachteile auf. Werden nur einzelne Kanten herangezogen, so ist die Genauigkeit des Ausrichtverfahrens durch die nur ungenau definierte exakte Kantenlage bestimmt (da die Kante nicht ideal stufenförmig, sondern kontinuierlich verläuft) und außerdem durch die Fehler, die bei der Abtastung der Kante entstehen. Die genaue Ausmessung einer Kante erfordert weiterhin eine nicht unbeträchtliche Zeit. Das Signal-/Rauschverhältnis der Kantenabtastung spielt hier außerdem eine Rolle, da die Kanten auf dem Wafer bei späteren Prozeßschritten durch darüberliegende Schichten (z. B. Oxidschichten oder Schichten des Photolacks) überdeckt sein können.

Bei der Verwendung von gitterförmigen Ausrichtstrukturen ergibt sich ein besseres Signal-/Rauschverhältnis, da alle Kanten des Gitters zum Ausrichtsignal beitragen. Zur Antastung dieses Ausrichtmusters ist jedoch ein relativ großer Lichtfleck erforderlich, so daß die Muster auf der Maske und dem Wafer relativ große Flächen bedecken. Außerdem können konstruktive Schwierigkeiten auftreten, wenn die optischen Auswerteeinrichtungen für die Beugungsanordnungen in herkömmliche photolithographische Anlagen eingebaut werden müssen.

Ein weiteres Verfahren zur Ausrichtung von Gegenständen ist aus DE-A-2 951 943 bekannt, bei dem periodische übereinander liegende Muster beider Objekte durch eine Abtastkamera in ein elektrisches Signal umgewandelt werden, um die Amplituden ausgewählter Fourierkomponenten zu bestimmen und diese als Maß für die Ausrichtung heranzuziehen. Da hier nur übereinander liegende Muster analysiert werden können, ist die Flexibilität dieser Anwendung für unterschiedliche Ausrichtprobleme eingeschränkt.

Die vorliegende Erfindung stellt sich daher die Aufgabe, ein Verfahren zur gegenseitigen Ausrichtung von Objekten der eingangs genannten Art anzugeben, mit dem schnell und automatisch Positioniergenauigkeiten im Submikronbereich erreicht werden können; die Einrichtungen zur Durchführung dieses Verfahrens sollen dabei keinen großen Aufwand benötigen und in bestehende Geräte eingebaut werden können.

Diese Aufgabe wird durch die in den Ansprüchen 1 und 7 gekennzeichnete Erfindung gelöst; Ausgestaltungen der Erfindung sind in den Unteransprüchen gekennzeichnet.

Bei dem vorgeschlagenen Verfahren werden als Ausrichtmuster periodische Strukturen in der Form optischer Strichgitter verwendet, die auf der Maske und dem Halbleiterwafer angebracht sind. Die Ausrichtmuster werden über geeignete optische Abbildungsmittel so auf eine Fernsehkamera projiziert, daß die Gitter vom Elektronenstrahl der Fernsehkamera senkrecht zur Richtung der Gitterkanten abgetastet werden. Die entstehenden elektrischen periodischen Signale, deren Periode der des Gitters entspricht, werden dann auf elektronischem Wege verarbeitet, um die relative Phase der beiden periodischen Signale festzustellen. Dazu werden die Signale entweder digitalisiert und einer schnellen digitalen Fourieranalyse unterzogen oder als Analogsignale einem phasenempfindlichen Verstärker zugeführt. In beiden Fällen wird aus dem festgestellten Phasenunterschied der beiden Gitter ein Maß für die relative Verschiebung gewonnen, das z. B. als Regelgröße für die automatische Ausrichtung verwendet werden kann.

Die Ausrichtmuster auf der Maske und dem Wafer können die gleiche oder auch verschiedene Gitterkonstanten aufweisen; im letztgenannten Fall treten Schwebungssignale auf, die einen sehr empfindlichen Indikator für die Ausrichtung darstellen.

Die hohe Genauigkeit des hier vorgeschlagenen Verfahrens beruht darauf, daß eine große Anzahl von Kanten zum auszuwertenden Signal beiträgt und somit Fehler in der Lage oder der Form einer einzelnen Kante ausgeglichen werden. Das Signal-/Rauschverhältnis ist entsprechend groß, ebenso die Empfindlichkeit. Im Vergleich zu Ausrichtverfahren, bei denen kohärentes Licht an optischen Gittern gebeugt wird und anschließend weitere optische Einrichtungen zur Auswertung des gebeugten Lichtes vorgesehen sind, z. B. Filter für ausgewählte Beugungsordnungen, elektrooptische Phasenkompensatoren usw., entfällt hier der Aufwand für den Laser und die optische Auswertung. Die Ausrichtmarken können überdies unbeeinflußt von Kohärenzforderungen so beleuchtet werden, daß sich auf der Fernsehkamera der bestmögliche Kontrast ergibt. Die Länge der einzelnen Gitterkanten kann hier außerdem sehr klein sein (im Extremfall entsprechend der Breite einer Fernsehzeile), so daß auf Maske und Wafer nur wenig Platz verbraucht wird. Kippungen der Ausrichtmuster bezüglich der abgetasteten Fernsehzeile können außerdem leicht erkannnt werden.

Der apparative Aufwand für die Durchführung des Verfahrens bleibt klein; die zur elektrooptischen Signalumformung verwendete Fernsehkamera wird in vielen Fällen sowieso schon Bestandteil der lithographischen Einrichtung sein, und die daran angeschlossenen elektronischen Komponenten (Analog/Digitalumwandler, Speicher, phasenempfindliche Verstärker, usw.) stehen alle als Standardbauteile mit entsprechend geringen Kosten zur Verfügung. Die Verarbeitungsgeschwindigkeit ist hoch, insbesondere auch wenn sie nach Umsetzung der Signale in Digitalwerte erfolgt, da z. B. bei der rechnerischen Fouriertransformation schnelle Algorithmen (sog. schnelle Fouriertransformation) zur Verfügung stehen, die von normalen Mikroprozessoren durchgeführt werden können.

Das hier vorgeschlagene Verfahren kann auch angewandt werden, um die Güte lithographischer Einrichtungen zu prüfen; dazu wird auf ein schon vorhandenes Muster auf dem Wafer das Muster einer Maske projiziert (und entwickelt) und anschließend an verschiedenen Punkten des Gesichtsfeldes mit Hilfe der obengenannten Gitterstrukturen die relative Abweichung beider voneinander bestimmt.

Ausführungsbeispiele der Erfindung werden nun anhand von Zeichnungen näher erläutert; es zeigen:

Fig. 1 die relative Lage von Ausrichtmarkierungen der hier vorgeschlagenen Art auf Maske und Wafer nach erfolgter Ausrichtung,

Fig. 2 das Blockschaltbild einer Einrichtung, mit der Ausrichtmarkierungen nach Fig. 1 mit digitalen Mitteln auf ihre relative Phase untersucht werden können,

Fig. 3 Zeitdiagramme der Signalfolge, die bei der Abtastung periodischer Ausrichtmarkierungen entstehen und die zugehörigen Grundwellen der Signalfolgen,

Fig. 4 das Blockschaltbild einer Einrichtung, mit der Ausrichtmarkierungen nach Fig. 1 mit analogen Mitteln auf ihre relative Phase untersucht werden können.

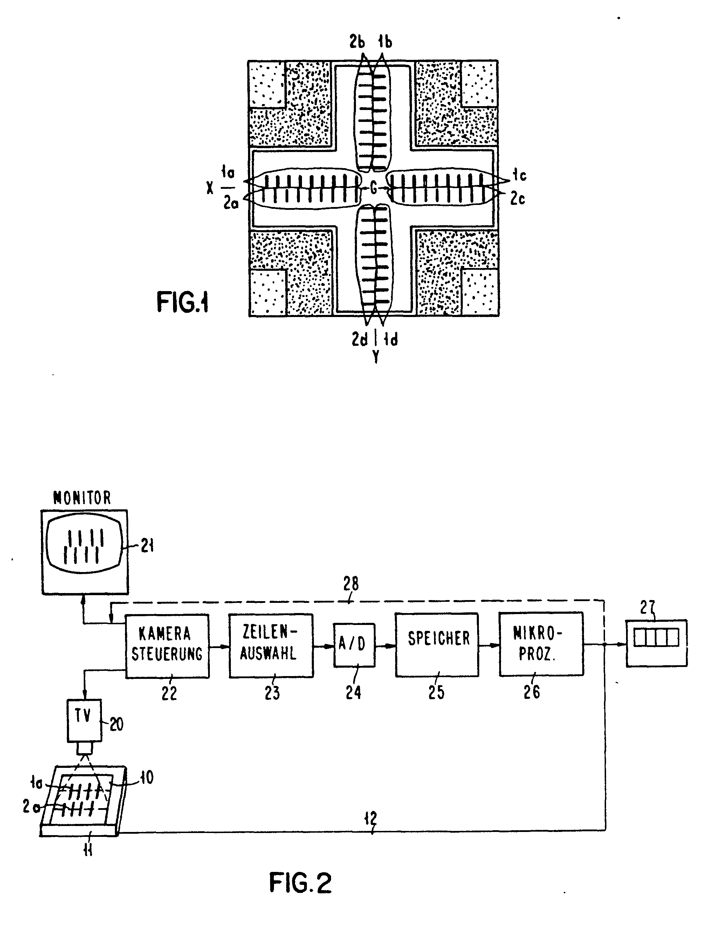

Fig. 1 zeigt das Bild, das sich einem Operator im Mikroskop zeigt, wenn heute gebräuchliche Ausrichtmarkierungen auf Maske und Wafer zur Deckung gebracht worden sind, Maske und Wafer also gegeneinander ausgerichtet sind. Die Ausrichtmarkierungen 1a bis 1d der Maske und 2a bis 2d des Wafers bestehen jeweils aus periodisch angeordneten Strichmarkierungen mit einem gegenseitigen Abstand von ungefähr 2,5 μ. Um beim Ausrichten eine Noniuswirkung zu erzielen, wird der Abstand zwischen den Strichmarkierungen der Maske etwas kleiner gewählt als bei den Strichmarkierungen des Wafers. Im Mittelpunkt des Kreuzes sind keine Strichmarkierungen angebracht, so daß in jeder der X- und Y-Koordinatenrichtungen ein Freiraum entsteht, beispielsweise der Breite G. Bei visueller Auswertung des Ausrichtmusters nach Fig. 1 lassen sich Genauigkeiten von rd. 1/10 des Strichabstandes, d.h. 0,25 μ erzielen.

Zur leichteren Beobachtung wird das in Fig. 1 dargestellte Bild in vielen Fällen nicht durch das Mikroskop betrachtet, sondern von einer Fernsehkamera aufgenommen und auf einem Monitor wiedergegeben. In einer derartigen Anordnung läßt sich das hier vorgeschlagene phasenempfindliche elektronische Ausrichtverfahren ohne jeden weiteren Eingriff in das Lithographiebild selbst durchführen, wenn der Ausgang der Fernsehkamera mit entsprechenden Auswerteschaltungen verbunden wird.

Die in Fig. 1 dargestellten periodischen Ausrichtmuster 1 bzw. 2 die im folgenden der Kürze halber als Gitter bezeichnet werden, brauchen für die Zwecke der vorliegenden Erfindung keine unterschiedlichen Gitterkonstanten aufzuweisen; ebenso wenig ist es nötig, daß in jeder Richtung zwei durch einen Abstand G voneinander getrennte Gitter vorhanden sind. Ausschlaggebend für die hier vorgeschlagene Ausrichtung ist nur, daß auf Maske und Wafer in jeder Richtung, in der eine Ausrichtung erfolgen soll, mindestens ein periodisches Gitter vorhanden ist. Die sonst im Stand der Technik üblichen Einzelkanten sind dagegen nicht geeignet.

Das erfindungsgemäße Ausrichtverfahren wird nun anhand einer bevorzugten Einrichtung beschrieben, deren Blockschaltbild in Fig. 2 dargestellt ist. Der in Fig. 1 dargestellte Bildausschnitt 10 mit den Gittern 1a, 2a wird von einer Fernsehkamera 20 mit zugehöriger Kamerasteuerung 22 in elektrische Signale umgesetzt und wahlweise auf einem Monitor 21 dargestellt. Die Wahl des Bildausschnitts 10 kann entweder manuell mit Hilfe des Monitors 21 erfolgen oder aber automatisch mit Hilfe von einfachen Bildverarbeitungsschaltungen 23, die auf die periodische Gitterstruktur reagieren und das Kamerabild entsprechend positionieren. Einzelheiten dazu werden im folgenden noch näher erläutert.

Wenn die Fernsehkamera so positioniert ist, daß ihre Abtastzeilen die Gitter 1a und 2a senkrecht zur Richtung der Gitterkonstanten erfassen, wird je eine dieser Abtastzeilen durch die Schaltung 23 ausgewählt und an Analog/Digitalwandler 24 gegeben, die das analoge Zeilensignal als Digitalwerte in einen Digitalspeicher 25 einspeichern.

Auch wenn die Ausrichtmuster so orientiert sind, daß sie vom Elektronenstrahl der Fernsehkamera nicht senkrecht, sondern parallel zu den Gitterkanten abgetastet werden, ist auch eine Auslesung möglich. Für diesen Fall werden die Signale aller Fernsehzeilen jeweils nur während eines kurzen zeitlichen Fensters registriert und in einem Speicher festgehalten. Die Lage und Dauer des zeitlichen Fensters ist für alle Zeilen gleich und so gewählt, daß das Ausrichtmuster erfaßt wird.

Die Folge der Einzelsignale aller Zeilen stellt das periodische Signal des Ausrichtmusters dar und kann digital oder - nach einer Digital/Analog-Umwandlung - auch analog weiterverarbeitet werden.

Die Feststellung, in welchem Bereich des Gesichtsfeldes die periodischen Ausrichtmuster liegen, kann also mit verschiedenen, dem Fachmann bekannten Methoden der Signalverarbeitung erfolgen.

Für die weitere erfindungsgemäße Verarbeitung muß aus den gespeicherten Digitalwerten durch eine von verschiedenen Möglichkeiten die Phase jedes der beiden durch die periodische Struktur bestimmten Signale ermittelt werden. Dies kann beispielsweise in einem Mikroprozessor 26 geschehen, der die den Signalen entsprechenden Digitalwerte aus dem Speicher 25 ausliest, nach bekannten und im folgenden noch näher erläuterten Algorithmen verarbeitet, um ein Ausgangssignal zu erzeugen, das der Phase bzw. der Phasendifferenz entspricht und auf einer Anzeigeeinheit 27 dargestellt werden kann. Statt der Einheit 27 kann auch der Monitor 21 zur symbolischen Anzeige der Phase herangezogen werden; eine Leitung 28 verbindet dann den Ausgang des Mikroprozessors 26 mit dem Monitor 21.

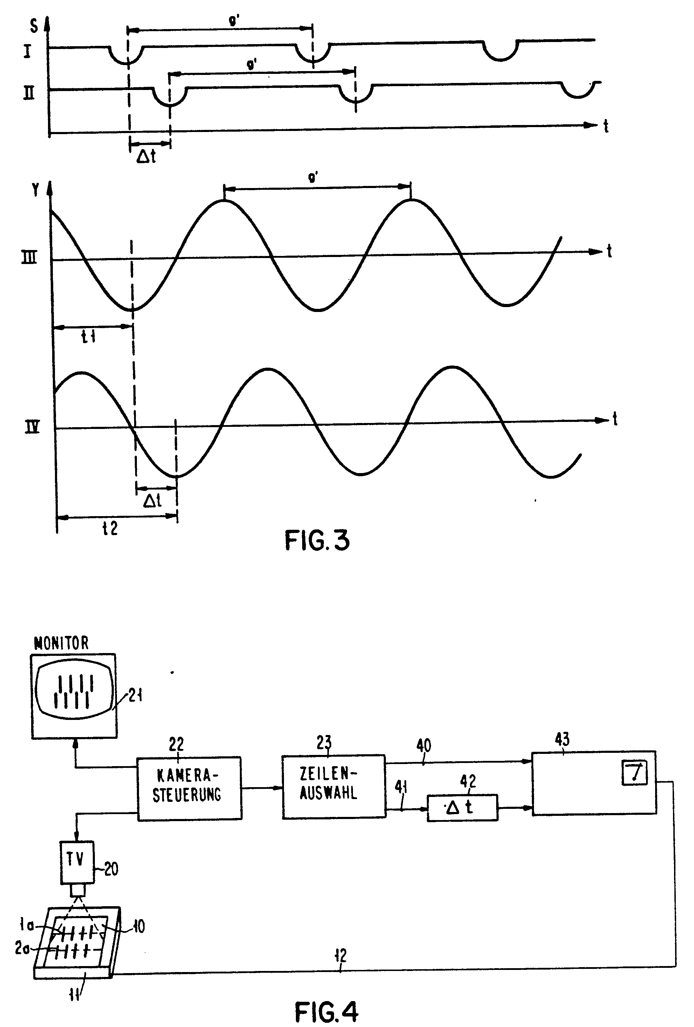

Fig. 3 zeigt in den Kurvenzügen I und II die elektrischen Ausgangssignale, die bei der Abtastung der Gitter 1a, 2a durch die Fernsehkamera 20 entstehen. In diesem Fall ist angenommen, daß beide Gitter dieselbe Gitterkonstante g haben (bzw. g' im Zeitdiagramm, wobei $g' = \frac{g}{v}$ mit $v$ = Abtastgeschwindigkeit des Elektronenstrahls der Fernsehkamera) und um einen Betrag $\Delta x$ gegeneinander versetzt sind, der sich im Zeitdiagramm als Verzögerung $\Delta t$ darstellt. Das Problem der genauen Ausrichtung besteht nun darin, den Betrag $\Delta t$ im abgetasteten Signal möglichst genau zu bestimmen, obwohl die Signale der einzelnen Gitterkante durch vielfältige Einflüsse verzerrt und verschmiert sein können, so daß die genaue Lage des einzelnen Minimums nicht genau bekannt ist.

Die Ungenauigkeiten, die bei der Abtastung einer Einzelkante unvermeidlich sind, werden nun erfindungsgemäß dadurch kompensiert, daß die Gesamtheit der Kanten für die elektronische Auswertung berücksichtigt wird. In ihrer allgemeinsten Form schlägt die Erfindung vor, aus periodischen Signalen der Art von I, II in Fig. 38x durch eine rechnerische Fouriertransformation mindestens die Grundwelle (bzw. die Grundfrequenz) zu bestimmen und deren Phasenlage bezüglich eines (willkürlich wählbaren) Bezugspunktes zu ermitteln. Die zu den Signalzügen I, II gehörigen Grundwellen, die sich bei dieser Fouriertransformation ergeben, sind in den Kurvenzügen III, IV schematisch dargestellt. Da nach den bekannten Fouriertheorien beliebige periodische Signalzüge in eine Vielzahl von Sinuswellen mit steigenden Frequenzen zerlegt werden können, stellt die Grundwelle eine ideale Sinuswelle mit der Periode g' dar, die von der Gesamtheit des periodischen Ausrichtmusters bestimmt wird und deren Phase (z. B. der Abstand des ersten Minimums von der Y-Achse) sehr genau ermittelt werden kann. Der Phasenunterschied beider Grundwellen ist dann:

$$\Delta \varphi = \varphi_2 - \varphi_1 = \frac{2\pi}{g} (t_2 - t_1)$$

Als Bezugspunkt kann beispielsweise der Beginn der Fernsehzeile herangezogen werden. Da die Phasen $\varphi_1$ und $\varphi_2$ nur bis auf Vielfache von $2\pi$ bestimmt sind und die Beziehung $t_1 = \frac{1}{2\pi} \cdot \varphi_1 \cdot g'$ besteht, muß bei gleichen Gittern auf Maske und Wafer eine Vorpositionierung so erfolgen, daß die Abweichung von der endgültigen Sollage kleiner als $g/2$ ist.

Die oben beschriebene harmonische Analyse der Abtastsignale ist auch anwendbar, wenn die Gitter auf Maske und Wafer jeweils verschiedene Gitterkonstanten (Periodizitäten) aufweisen; dieser Fall ist sogar besonders günstig, da dann die beiden ermittelten Grundfrequenzen elektronisch überlagert werden können und Schwebungen bilden, die bei geeigneter Wahl der beiden Gitterkonstanten, auch bei nur grober Vorausrichtung, ein eindeutiges Ausrichtsignal liefern. Da die resultierende Gitterkonstante der Schwebung bei Überlagerung zweier Gitter mit den jeweiligen Gitterkonstanten $g_1$ und $g_2$ proportional zum Wert $1/(g_2-g_1)$ ist, können die Einzelgitter so ausgewählt werden, daß nur ein Maximum der Grundwelle des Überlagerungsgitters in dem Bereich auftritt, der durch die Längsausdehnung der beiden Einzelgitter definiert ist. Die Lage dieses Maximums hängt dabei empfindlich von Verschiebungen der Einzelgitter ab, so daß ein sehr genaues Maß für die ideale Ausrichtposition zur Verfügung steht. Die Errechnung der Lage dieses Maximums und die Umsetzung in einen Anzeigewert erfolgt wieder über den Mikroprozessor 26.

Eine weitere Ausgestaltung der harmonischen Analyse betrifft den in Fig. 1 dargestellten Fall, daß in jeder Koordinatenrichtung zwei durch eine Lücke getrennte Teilgitter vorgesehen sind. Da derartige periodische Strukturen ebenfalls durch ein eindeutiges Fourierspektrum bestimmt sind, gelten die obigen Ausführungen auch für diesen Fall. Die Lücke zwischen den beiden Teilgittern drückt sich in der mathematischen Darstellung nur durch eine zusätzliche feste Phasendifferenz $2\pi G/g$ aus. Die resultierende Gesamtwelle läßt sich dann beispielsweise für das auf der Maske angebrachte Gitter mit der Gitterkonstanten $g_1$ folgendermaßen ausdrücken:

$$\sin(2\pi x/g_1 + \varphi_1) + \sin(2\pi x/g_1 + \varphi_1 + 2\pi G/g_1)$$
$$= 2\sin(2\pi x/g_1 + \varphi_1 + \pi G/g_1) \cdot \cos(\pi G/g_1).$$

Entsprechendes gilt für die Grundwelle des Ausrichtmusters auf dem Wafer mit der Gitterkonstanten $g_2$:

$$2\sin(2\pi x/g_2 + \varphi_2 + \pi G/g_2) \cdot \cos(\varphi G/g_2).$$

Die relativen Phasen dieser beiden Wellen sind also

$$\varphi_I = \varphi_1 + \pi G/g_1$$

und

$$\varphi_{II} = \varphi_2 + \pi G/g^2$$

Damit können die resultierenden Wellen bis auf den konstanten Cosinusfaktor dargestellt werden als

$$\sin(2\pi x/g_1 + \varphi_I)$$

und

$$\sin(2\pi x/g_2 + \varphi_{II}).$$

Das Kriterium für eine vollständige Ausrichtung ist in diesem Fall die Phasenübereinstimmung der Grundwellen beider Muster an einem vorgegebenen Punkt; im Fall des Ausrichtmusters nach Fig. 1, in dem bei visueller Justierung die innen liegenden Gitterkanten zur Deckung gebracht werden, liegt für die harmonische Analyse dann eine Ausrichtung vor, wenn die Phasen der Grundwellen am rechten Ende des linken Ausrichtmusters und am linken Ende des rechten Ausrichtmusters übereinstimmen. In Bezug auf die Überlagerungswellen ist die Ausrichtung erfolgt, wenn die Überlagerungswellen im Mittelpunkt der Lücke G gleiche Phase aufweisen. Wird der Ort gleicher Phase der Überlagerungswellen, wie oben beschrieben, auf dem Monitor symbolisch angezeigt, beispielsweise durch eine eingeblendete helle oder dunkle senkrechte Markierungslinie, so geht bei erfolgter Ausrichtung (Phasengleichheit) diese Markierungslinie genau durch die Mitte der Lücke G. Umgekehrt wandert die Markierungslinie über die gesamte Längsausdehnung der Ausrichtmuster, wenn sich eines der Gitter um den Strichabstand $g_1$ bzw. $g_2$ verschiebt. Diese Verschiebung ist in der Bewegung der Markierungslinie also sehr stark vergrößert und kann entsprechend genau ausgelesen werden.

Der Aufwand für die Berechnung der Frequenzkomponenten des abgetasteten Musters mit Hilfe der Fouriertransformation ist mit den heute zur Verfügung stehenden Mitteln leicht tragbar; in den vergangenen Jahren wurden für diesen Zweck besonders schnelle Rechenalgorithmen entwickelt (sog. FFT = Fast Fourier Transform), die mit relativ geringem Rechenaufwand eine Echtzeit-Ermittlung des Fourierspektrums erlauben. Die Rechenarbeit kann dabei ohne weiteres von einem der heute als integriertes Schaltkreisplättchen zur Verfügung stehenden Mikroprozessoren bewältigt werden. Die Kapazität des digitalen Speichers zur Aufnahme der digitalisierten Signalformen stellt ebenfalls keine Probleme an Technik und Wirtschaftlichkeit.

Der Aufwand für die Berechnung der jeweiligen Phasen kann noch weiter reduziert werden, wenn für die Ausrichtmuster gewisse, in der Praxis nicht störende Einschränkungen bestehen. Werden als Ausrichtmuster immer Gitter mit derselben Gitterkonstante g verwendet, so braucht die dann bekannte Grundfrequenz des Gitters nicht erst bestimmt zu werden. In derartigen Fällen genügt es zur Bestimmung der Phase, das Abtastsignal punktweise abzutasten, wobei nach dem Abtasttheorem auf jeder der einer Gitterkonstanten entsprechenden Strecke drei Abtastpunkte liegen müssen. Der Mikroprozessor 26 adressiert dazu den Speicher 25 in gleichen Adreßschritten und ermittelt aus der Gesamtzahl dieser Abtastwerte nach Mittelwertbildung die gewünschte Phase.

In Fig. 4 ist eine weitere Einrichtung zur phasenempfindlichen Ausrichtung in Form eines Blockdiagramms dargestellt, in der analoge Auswertemittel vorgesehen sind. Der linke Teil dieser Einrichtung entspricht dem der Fig. 2. Die Schaltung 23 für die Zeilenauswahl weist hier jedoch zwei parallele Ausgänge mit Leitungen 40 und 41 auf, die jeweils das Analogsignal der Abtastung der Ausrichtmuster 1a und 2a führen. Da eine dieser Zeilen zeitlich vor der anderen abgetastet wird, ist in der Leitung für diese früher abgetastete Zeile eine Verzögerungseinrichtung 42 vorgesehen, die den Zeitverlust der später abgetasteten Zeile ausgleicht. Die beiden bezüglich der verschiedenen Abtastzeiten aufeinander ausgerichteten Signale gelangen dann zu den Eingängen einer phasenempfindlichen Detektorschaltung 43, die im Stand der Technik beispielsweise unter dem Namen Lock-in-Verstärker bekannt sind. Das Ausgangssignal einer derartigen phasenempfindlichen Detektorschaltung gibt den zeitlichen Unterschied (die Phasendifferenz) der beiden Eingangssignale wieder. Für die vorliegende Anwendung stellt dieses Ausgangssignal also direkt ein Maß für die Güte der gegenseitigen Ausrichtung von Maske und Wafer dar. Als Verzögerungseinrichtung für die analogen Signale können beispielsweise Verzögerungsleitungen mit verschiebbarem Abgriff verwendet werden, wie sie im Stand der Technik bekannt sind. Da die phasenempfindlichen Detektoreinrichtungen im Vergleich zur Frequenz des Abtastsignals relativ träge arbeiten, erfolgt auch dort eine Mittelung über die Signale mehrerer Kanten des Gitters und somit eine gegenüber der Einfachmessung erhöhte Ausrichtgenauigkeit.

Die Auswahl des Bildausschnittes 10 (für jede der beiden Koordinatenrichtungen) kann automatisch mit Hilfe von Verfahren erfolgen, wie sie auf dem Gebiet der Mustererkennung bekannt sind. Als Möglichkeit kommt hier auch in Betracht, analoge oder digitale Filter vorzusehen, die auf die bekannte Ortsfrequenz der Gitter ansprechen und beispielsweise in der Schaltung 23 für die Zeilenauswahl untergebracht sind. Eine andere Möglichkeit besteht darin, größere Teile des Gesichtsfeldes der Fernsehröhre zu digitalisieren und entsprechende Algorithmen für die Mustererkennung im Mikroprozessor 26 vorzusehen. Auch eine manuelle Justierung der Abbildung der Ausrichtmuster auf ausgewählte Abtastzeilen der Fernsehkamera mit Hilfe eines Monitors ist möglich; die ausgewählten Abtastzeilen geben dann über entsprechende elektronische Schaltungen das periodische Ausgangsignal ab.

Soll das Ausrichtsignal in einer Regelschleife zur vollautomatischen Ausrichtung verwendet werden, so kann dies mit einer Ausgangsleitung 12 geschehen, die entsprechende Stellmittel eines X/Y-Tisches 11 beaufschlagt.

Bei der hier vorgeschlagenen elektronischen Bestimmung der Phase eines oder mehrerer als Gitter ausgestalteter Ausrichtmarken ermöglicht also insgesamt eine sehr flexible Anpassung an verschiedene Arten und Anordnungen von Ausrichtmarken. Eingriffe in das optische System der lithographischen Anordnung sind nicht nötig; andererseits kann die Beleuchtung der Marken ohne Schwierigkeiten im Einzelfall so gewählt werden, daß sich am Ausgang der Fernsehkamera ein optimales Signal ergibt. Die Ausrichtung zwischen der Längsrichtung der Marke und der Abtastrichtung der Fernsehkamera ist nicht kritisch, da eine Winkelfehllage leicht durch zweimaliges Abtasten im oberen bzw. unteren Teil des Gitters erkannt und auf elektronischem Wege korrigiert werden kann.

**Patentansprüche**

1. Verfahren zur gegenseitigen Ausrichtung von zwei Objekten, bei dem periodisch strukturierte, auf beiden Objekten angebrachte Ausrichtmuster abgetastet und in periodische elektrische Signale umgeformt werden, die zur Erzeugung von Ausrichtsignalen analysiert werden,
dadurch gekennzeichnet,
daß die Ausrichtmuster (1a, 2a) jeweils getrennt abgetastet werden und daß als Maß der Ausrichtung der Phasenunterschied ausgewählter Fourierkomponenten beider Abtastsignale verwendet wird.

2. Verfahren nach Anspruch 1,
dadurch gekennzeichnet,
daß der Phasenunterschied der Grundwellen im Fourierspektrum ermittelt wird.

3. Verfahren nach Anspruch 1 oder 2,
dadurch gekennzeichnet,
daß die Elemente beider Ausrichtmuster jeweils gleiche Abstände (gleiche Ortsfrequenz) aufweisen.

4. Verfahren nach Anspruch 1 oder 2,
dadurch gekennzeichnet,
daß die Elemente beider Ausrichtmuster verschiedene Abstände (verschiedene Ortsfrequenzen) aufweisen.

5. Verfahren nach einem der Ansprüche 1 - 4,
dadurch gekennzeichnet,

daß die Ausrichtmuster Lücken in ihrem periodischen Verlauf aufweisen und daß als Maß der Ausrichtung der Phasenunterschied der Grundwellen des Fourierspektrums an den Begrenzungen der Lücke im periodischen Ausrichtmuster verwendet wird.

6. Verfahren nach einem der Ansprüche 1 - 5, dadurch gekennzeichnet, daß zwei gleiche Fourierkomponenten (z. B. die Grundwellen) elektronisch überlagert werden und das resultierende Signal als Maß für die Ausrichtung dient.

7. Verfahren nach einem der Ansprüche 1 - 6, dadurch gekennzeichnet, daß die Ausrichtmuster Lücken in ihrem periodischen Verlauf aufweisen und zwei gleiche Fourierkomponenten (z. B. die Grundwellen) beider Teile eines Ausrichtmusters elektronisch überlagert werden und daß der Phasenunterschied der Überlagerungswellen beider Ausrichtmuster in der Mitte der Lücke der Ausrichtmuster als Maß der Ausrichtung dient.

8. Verfahren nach einem der Ansprüche 1 - 7, dadurch gekennzeichnet, daß die periodischen elektrischen Signale digitalisiert und einer rechnerischen Fourieranalyse unterzogen werden.

9. Verfahren nach einem der Ansprüche 1 - 8, dadurch gekennzeichnet, daß die Grundwelle der Fourierkomponenten durch Abtastung der elektrischen Signale an mindestens drei Punkten der Periode eines Ausrichtmusters ermittelt wird.

10. Einrichtung zur gegenseitigen Ausrichtung von zwei Objekten mit einer Abtastkamera zur Abtastung von periodisch strukturierten, auf jedem Objekt angebrachten Ausrichtmustern zur Erzeugung von periodischen elektrischen Signalen und mit Vorrichtungen zur Auswertung der Fourierkomponenten der periodischen Signale, dadurch gekennzeichnet, daß der Abtastkamera (20) eine Einrichtung (23) nachgeschaltet ist, mit der die periodischen Abtastsignale der Ausrichtmuster ausgefiltert und als analoge Ausgangssignale abgegeben werden und daß die Auswertevorrichtungen den Phasenunterschied ausgewählter Fourierkomponenten der analogen Ausgangssignale bestimmen.

11. Einrichtung nach Anspruch 10, dadurch gekennzeichnet, daß die analogen Ausgangssignale digitalisiert und in einem Speicher abgelegt werden, zu dem ein Prozessor (26) Zugriff hat.

12. Einrichtung nach Anspruch 10, dadurch gekennzeichnet, daß die analogen Ausgangssignale einem phasenempfindlichen Verstärker (43) zugeführt werden, wobei das Signal des zuerst abgetasteten Ausrichtmusters eine Verzögerungseinrichtung (42) durchläuft.

13. Einrichtung nach einem der Ansprüche 8 - 10, dadurch gekennzeichnet, daß ein an die Abtastkamera (20) angeschlossener Monitor (21) vorgesehen ist, dem das die ermittelte Ausrichtung darstellende Signal zur visuellen Anzeige eingeblendet wird.

**Claims**

1. Method for the mutual alignment of two objects, wherein periodically structured alignment patterns, provided on both objects, are scanned and converted into periodical electrical signals which are analyzed for generating alignment signals, characterized in that the alignment patterns (1a, 2a) are scanned separately in each case, and that the phase difference of selected Fourier components of both scanning signals is used as a measure of alignment.

2. Method according to claim 1, characterized in that the Phase difference of the fundamental waves in the Fourier spectrum is determined.

3. Method according to claim 1 or 2, characterized in that the elements of both alignment patterns have identical spacings (identical spatial frequencies) in each case.

4. Method according to claim 1 or 2, characterized in that the elements of both alignment patterns have different spacings (different spatial frequencies).

5. Method according to any one of the claims 1 to 4, characterized in that the alignment patterns have gaps in their periodical structure, and that the phase difference of the fundamental waves of the Fourier spectrum at the boundaries of the gap in the periodical alignment pattern is used as a measure of alignment.

6. Method according to any one of the claims 1 to 5, characterized in that two identical Fourier components (e.g., the fundamental waves) are electronically superimposed upon each other and the resultant signal serves as a measure of alignment.

7. Method according to any one of the claims 1 to 6, characterized in that the alignment patterns have gaps in their periodical structure and two identical Fourier components (e.g., the fundamental waves) of both parts of an alignment pattern are electronically superimposed upon each other, and that the phase difference of the superimposed waves of both alignment patterns in the center of the gap of the alignment patterns serves as a measure of alignment.

8. Method according to any one of the claims 1 to 7, characterized in that the periodical electrical signals are digitized and subjected to computational Fourier analysis.

9. Method according to any one of the claims 1 to 8,

characterized in that the fundamental wave of the Fourier components is determined by sampling the electrical signals at least at three points of the period of an alignment pattern.

10. Apparatus for the mutual alignment of two objects, comprising

a camera for scanning periodically structured alignment patterns, provided on each object, for generating periodical electrical signals, and

means for evaluating the Fourier components of the periodical signals,

characterized in that the scanning camera (20) is followed by a means (23) causing the periodical scanning signals of the alignment patterns to be filtered out and emitted as analog output signals, and that the evaluating means determines the phase difference of selected Fourier components of the analog output signals.

11. Apparatus according to claim 10,

characterized in that the analog output signals are digitized and stored in a storage which is accessed by a processor (26).

12. Apparatus according to claim 10,

characterized in that the analog output signals are fed to a phase-sensitive amplifier (43), with the signal of the alignment pattern scanned first being fed through a delay means (42).

13. Apparatus according to any one of the claims 8 to 10,

characterized in that a monitor (21), connected to the scanning camera (20), is provided, into which the signal representing the alignment determined is inserted for visual display.

## Revendications

1. Procédé pour aligner réciproquement deux objets, selon lequel des dessins d'alignement à structure périodique, disposés sur les deux objets, sont explorés et convertis en signaux électriques périodiques qui sont analysés pour produire des signaux d'alignement, caractérisé en ce qu'on explore les dessins d'alignement (1a, 2a) séparément l'un de l'autre en ce qu'on utilise comme mesure de l'alignement, la différence de phase de composantes de Fourier sélectionnées des deux signaux d'exploration.

2. Procédé selon la revendication 1, caractérisé en ce qu'on détermine la différence de phase des ondes de base dans le spectre de Fourier.

3. Procédé selon la revendication 1 ou 2, caractérisé en ce que les éléments des deux dessins d'alignement possèdent des distances réciproques identiques (même fréquence locale).

4. Procédé selon la revendication 1 ou 2, caractérisé en ce que les éléments des deux dessins d'alignement possèdent des distances réciproques différentes (fréquen ces locales différentes).

5. Procédé selon l'une des revendications 1 à 4, caractérisé en ce que les dessins d'alignement comportent des interruptions dans leurs variations périodiques et qu'on utilise comme mesure de l'alignement, la différence de phase des ondes de base du spectre de Fourier au niveau des limites des interruptions dans le dessin périodique d'alignement.

6. Procédé selon l'une des revendications 1 à 5, caractérisé en ce qu'on superpose par voie électronique deux composantes identiques de Fourier (par exemple les ondes de base) et qu'on utilise le signal obtenu en tant que mesure de l'alignement.

7. Procédé selon l'une des revendications 1 à 6, caractérisé en ce que les dessins d'alignement comportent des interruptions dans leur variation périodique et qu'on superpose par voie électronique deux composantes identiques de Fourier, (par exemple les ondes de base) des deux éléments d'un dessin d'alignement et qu'on utilise la différence de phase des ondes de superposition des deux dessins d'alignement au centre de l'interruption des dessins d'alignement, en tant que mesure de l'alignement.

8. Procédé selon l'une des revendications 1 à 7, caractérisé en ce que l'on numérise les signaux électriques périodiques et qu'on les soumet à une analyse de Fourier effectuée par calcul.

9. Procédé selon l'une des revendications 1 à 7, caractérisé en ce que l'onde de base des composantes de Fourier est déterminée par exploration des signaux électriques en au moins trois points de la période du dessin d'alignement.

10. Dispositif pour aligner réciproquement deux objets, comportant une caméra d'exploration servant à explorer des dessins d'alignement à structure périodique disposés sur chaque objet, pour la production de signaux électriques périodiques, et des dispositifs pour évaluer les composantes de Fourier des signaux périodiques, caractérisé en ce qu'en aval de la caméra d'exploration (20) se trouve branché un dispositif à l'aide duquel les signaux périodiques d'exploration des dessins d'alignement sont séparés par filtrage et sont délivrés sous la forme de signaux de sortie analogiques et que les dispositifs d'évaluation déterminent la différence de phase de composantes sélectionnées de Fourier des signaux de sortie analogiques.

11. Dispositif selon la revendication 10, caractérisé en ce que les signaux de sortie analogiques sont numérisés et introduits dans une mémoire, à laquelle un processeur (26) a accès.

12. Dispositif selon la revendication 10, caractérisé en ce que les signaux de sortie analogiques sont envoyés à un amplificateur (43) sensible à la phase, le signal du dessin d'alignement exploré en premier lieu traversant un dispositif à retard (42).

13. Dispositif selon l'une des revendications 8 à 10, caractérisé en ce qu'il est prévu un moniteur (21) raccordé à la caméra d'exploration (20) et dans lequel le signal représentant l'alignement déterminé est injecté en vue d'un affichage optique.

FIG.1

FIG.2

FIG.3

FIG.4